# EUROPÄISCHE PATENTSCHRIFT

(11) **EP 2 624 968 B1**
(45) Veröffentlichungstag und Bekanntmachung des Hinweises auf die Patenterteilung: **28.12.2016**
(21) Anmeldenummer: 11775750.0
(22) Anmeldetag: 04.10.2011
(51) Int. Cl.: B06B 1/06, H01L 41/053

(54) **VORRICHTUNG UND VERFAHREN ZUR VERSPANNUNG VON ELEKTROMECHANISCHEN VERBUND-HOCHFREQUENZSCHWINGSYSTEMEN (VFHS)**
DEVICE AND METHOD FOR BRACING ELECTROMECHANICAL COMPOSITE HIGH-FREQUENCY VIBRATION SYSTEMS (VFHS)
DISPOSITIF ET PROCÉDÉ POUR CONTRAINDRE DES SYSTÈMES GÉNÉRATEURS D'OSCILLATIONS HAUTE FRÉQUENCE COMPOSITES

(30) Priorität: 04.10.2010 US 389337 P
(43) Veröffentlichungstag der Anmeldung: 14.08.2013
(73) Patentinhaber: Dr. Hielscher GmbH, 14513 Teltow (DE)
(72) Erfinder: HIELSCHER, Thomas, 14467 Potsdam (DE); HIELSCHER, Harald, 14532 Stahnsdorf (DE); HIELSCHER, Holger, 14513 Teltow (DE)
(74) Vertreter: Gulde & Partner
(86) Internationale Anmeldenummer: PCT/EP2011/067342
(87) Internationale Veröffentlichungsnummer: WO 2012/045755

(56) Entgegenhaltungen:
- EP-A2- 0 243 591
- GB-A- 2 137 024
- US-A- 4 420 826
- US-A- 4 499 566
- US-A- 5 798 599
- US-A1- 2006 180 386
- US-A1- 2008 015 443

## Beschreibung

Die Erfindung betrifft eine Vorrichtung zur Verspannung von elektromechanischen Verbund-Hochfrequenzschwingsystemen (VFHS). Derartige Vorrichtungen sind beispielsweise in EP 0 243 591 A2 und US 4,499,566 A offenbart.

### Problemstellung

Niederfrequenz-Leistungs-Ultraschall (NFLUS) ist Ultraschall mit einer Arbeitsfrequenz von 15 bis 200 kHz, vorzugsweise 15 bis 60 kHz, z.B. 20 kHz und einer Schallleistung über 10 W, vorzugsweise 100 W bis 20.000 W, z.B. 10.000 W. Zur Erzeugung des Ultraschalls werden beispielsweise piezokeramische oder magnetostriktive Systeme verwendet. Es sind lineare Schallwandler und flächige oder gewölbte Plattenschwinger oder Rohrresonatoren bekannt. Niederfrequenz-Leistungs-Ultraschall findet unter anderem in der Behandlung von Flüssigkeiten, wie z.B. Nahrungsmitteln, Kosmetika, Farben und Nanomaterialien Verwendung. Dafür wird Ultraschall über einen Resonator mit Amplituden von 1 bis 350 µm, vorzugsweise 10 bis 80 µm, z.B. 35µm in Flüssigkeiten übertragen. Lambda ist die Wellenlänge welche sich aus der NFLUS-Frequenz und der Schallausbreitungsgeschwindigkeit im Hochfrequenzschwingsystem ergibt. Ein Hochfrequenzschwingsystem kann aus einem oder mehreren Lambda/2-Elementen bestehen. Ein aus mehreren Lambda/2-Elementen bestehendes Hochfrequenzschwingsystem kann aus einem Materialstück entsprechender Länge gefertigt werden oder aus mehreren Elementen der Länge n*Lambda/2 (n ∈ N), z.B. durch Verschrauben zusammengesetzt werden. Lambda/2-Elemente können verschiedene Materialquerschnittgeometrien, z.B. kreisförmige, ovale oder rechteckige Querschnitte aufweisen. Die Querschnittsgeometrie und -fläche kann entlang der Längsachse eines Lambda/2-Elements variieren. Die Querschnittfläche kann zwischen 0,01 und 300cm², vorzugsweise zwischen 10 und 100cm², z.B. 50cm² betragen. Lambda/2-Elemente können unter anderem aus metallischen oder keramischen Materialien oder aus Glas, insbesondere aus Titan, Titanlegierungen, Stahl oder Stahllegierungen, Aluminium oder Aluminiumlegierungen, z.B. aus Titan grade 5 gefertigt sein. Ein Lambda/2-Element kann einem Materialstück entsprechender Länge gefertigt werden oder aus mehreren miteinander verbundenen Materialstücken bestehen.

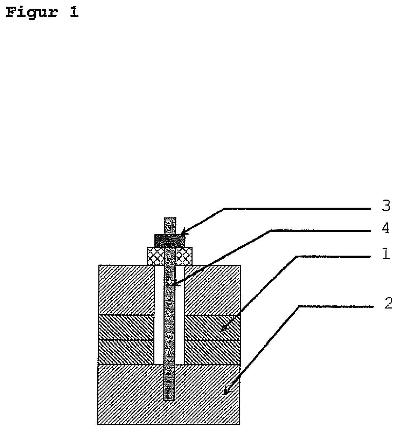

Hochfrequenzschwingsysteme und Lambda/2-Elemente, welche aus mehr als einem Materialstück bestehen können auf verschiedene Weise zu einem Verbund zusammen gefügt werden. Eine typische Form des Verbundes ist ein mittels zentrisch positionierten Spannelements komprimiertes Hochfrequenzschwingsystem (Figur 1). Piezokeramische Verbund-Hochfrequenzschwingsysteme bestehen aus einem oder mehreren in Längsrichtung verbunden Lambda/2-Elementen, von welchen mindestens eines ein oder mehrere piezokeramische Elemente, z.B. Scheiben, Ringe, Scheibensegmente oder Ringsegmente aufweist. Für Niederfrequenz-Hochleistungssystem werden Verbund-Hochfrequenzschwingsysteme mit mehreren piezokeramischen Elementen, vorzugsweise mit mehr als vier piezokeramischen Elementen, z.B. mit acht piezokeramischen Elementen eingesetzt.

Gerade piezokeramische Verbund-Hochfrequenzschwingsysteme erfordern eine erhöhte Flächenpressung der piezokeramischen Elemente. Diese Flächenpressung kann zwischen 0,1 und 1000 N/mm², vorzugsweise zwischen 40 und 300 N/mm², z.B. 100 N/mm² betragen. Die Flächenpressung hat erhebliche Auswirkungen auf den Wirkungsgrad, die maximal mögliche Ultraschallleistung und auf die Resonanzfrequenz. Daher kann die Flächenpressung unter anderem so gewählt werden, dass der Wirkungsgrad maximiert und/oder die thermischen Verluste bei der Umwandlung von elektrischer in mechanische Arbeit minimiert werden.

Die Flächenpressung wird durch mindestens ein Spannelement, z.B. durch eine zentrisch positionierte Spannschraube erzeugt. In Abhängigkeit von der aufgebrachten Flächenpressung ergibt sich eine Zugbelastung der Spannelemente. Die Zugbelastungsfähigkeit der einzelnen Spannelemente bedingt eine minimal notwendige Summe der Materialquerschnitte der einzelnen Spannelemente. Im Falle innenliegender, z.B. zentrisch angeordneter Spannelemente, reduziert die Materialquerschnittsumme der Spannelemente den Materialquerschnitt der ultraschallerzeugenden, z.B. der piezokeramischen, Elemente. Die maximale Diagonale und somit die maximal mögliche Querschnittfläche der der ultraschallerzeugenden, z.B. der piezokeramischen, Elemente ist bautechnisch begrenzt, da bei zunehmender Diagonalen sowohl die Tendenz zu zerstörerischen Biegeschwingungen z.B. der Piezoelemente und Materialstücke zunimmt, als auch die thermische Ableitfähigkeit durch einen erhöhten durchschnittlichen Abstand zur nichtbedeckten Oberfläche der ultraschallerzeugenden Elemente zunimmt. Da die Querschnittfläche der ultraschallerzeugenden Elemente somit nicht beliebig groß gewählt werden kann, reduziert der erforderliche die Spannelemente-Materialquerschnitt die maximal mögliche Querschnittfläche der ultraschallerzeugenden Elemente.

Der Erfindung liegt die Aufgabe zugrunde, eine Vorrichtung anzugeben, mit welcher elektromechanische Verbund-Hochfrequenzschwingsysteme verspannt werden können, ohne den Materialquerschnitt der ultraschallerzeugenden Elemente zu reduzieren.

Erfindungsgemäß wird die Aufgabe gelöst durch die Merkmale des Anspruchs 1. Zweckmäßige Ausgestaltungen sind Gegenstand der Unteransprüche.

Erfindungsgemäß wird eine Vorrichtung zur Erzeugung von elektromechanischen Verbund-Hochfrequenzschwingungen zur Verfügung gestellt, welche ein Verbund-Hochfrequenzschwingsystem mit mindestens einem schwingungserzeugendem Element und mindestens ein Spannelement zur Druckbeaufschlagung des schwingungserzeugenden Elementes umfasst, wobei mindestens ein Spannelement außerhalb des Materialquerschnitts mindestens eines schwingungserzeugenden Elementes positioniert ist.

Dadurch wird die Anordnung von innenliegenden, z.B. zentrisch angeordneten Spannelementen vermieden, die in ihrer maximalen Querschnittsgeometrie durch die umgebenden ultraschallerzeugenden Elemente begrenzt sind und zur Ausbildung von Biegeschwingungen neigen. Insbesondere bei piezokeramischen Verbund-Hochfrequenzschwingsystemen, welche aus mehreren in Längsrichtung verbunden Lambda/2-Elementen und innenliegenden, z.B. zentrisch angeordneten Spannelementen bestehen, ergibt sich durch das hohe Aspektverhältnis (Länge zu Querschnittsdiagonale) des Spannelements (oder der Spannelemente) eine hohe Tendenz von Biegeschwingungen. Diese können durch die erfindungsgemäße Ausbildung der Erfindung mit außen angeordneten Spannelementen eliminiert oder mindestens erheblich reduziert werden.

In einer günstigen Ausgestaltungsvariante der Erfindung sind mindestens zwei Spannelemente außerhalb des Materialquerschnitts mindestens eines schwingungserzeugenden Elementes positioniert.

Die erzeugten Schwingungen sind vorzugsweise Ultraschall.

Das Verbund-Hochfrequenzschwingsystem ist dazu ausgelegt, mit einer Frequenz zwischen 15 und 200 kHz, insbesondere zwischen 15 und 60 kHz und in bevorzugter Ausführungsform zwischen 15 und 35 kHz zu schwingen.

Weiterhin ist das Verbund-Hochfrequenzschwingsystem für die Erzeugung von Schwingungen mit einer Amplitude von 1 bis 350 µm, insbesondere mit einer Amplitude von 10 bis 80 µm ausgelegt.

Dabei ist das Verbund-Hochfrequenzschwingsystem für die Übertragung von Ultraschall mit einer Leistung von 100 bis 20.000 Watt , insbesondere mit einer Leistung von 4.000 bis 20.000 Watt ausgelegt.

Vorteilhafterweise sind die schwingungserzeugenden Elemente piezokeramische Elemente.

Das heißt, dass das Verbund-Hochfrequenzschwingsystem insbesondere piezokeramische Elemente zur Erzeugung der Schwingungen verwenden kann.

Dabei können die piezokeramischen Elemente piezokeramische Scheiben oder Scheibensegmente sein.

Alternativ kann das Verbund-Hochfrequenzschwingsystem piezokeramische Ringe oder Ringsegmente zur Erzeugung der Schwingungen verwenden.

Es kann vorgesehen sein, dass das Verbund-Hochfrequenzschwingsystem piezokeramische Elemente mit einer Diagonalen von mehr als 30 mm, insbesondere mehr als 50 mm und in besonders bevorzugter Ausführungsform mehr als 70 mm zur Erzeugung der Schwingungen verwendet.

Das Verbund-Hochfrequenzschwingsystem ist insbesondere zur Übertragung von Ultraschall in Flüssigkeiten eingerichtet.

Das Verbund-Hochfrequenzschwingsystem ist vornehmlich für den Dauerbetrieb und insbesondere für den Betrieb mit konstanter Amplitude oder konstanter Last über einen Zeitraum von mehr als einer Stunde auslegt.

In einer vorteilhaften Ausgestaltung der Erfindung weist das Verbund-Hochfrequenzschwingsystem mindestens zwei, insbesondere mindestens drei entlang seiner Längsrichtung hintereinander angeordnete Lambda/2-Elemente auf.

Dabei können mindestens zwei Lambda/2-Elemente jeweils mindestens ein piezoelektrisches Element aufweisen.

Alternativ ist vorgesehen, dass mindestens zwei Lambda/2-Elemente jeweils mindestens zwei piezoelektrische Elemente aufweisen.

Vorzugsweise beträgt die an den piezokeramische Elementen anliegende Flächenpressung an mindestens einer Stelle zwischen 0,1 und 1000N/mm², insbesondere zwischen 40 und 300N/mm².

Generell sollte die die an den piezokeramische Elementen anliegende Flächenpressung so gewählt sein, das die thermischen Verluste bei der Umwandlung von elektrischer in mechanische Arbeit reduziert werden.

In einer Ausführungsform der erfindungsgemäßen Vorrichtung ist vorgesehen, dass mindestens zwei außen positionierte Spannelemente verwendet werden.

Die Summe der Querschnittminima der verwendeten Spannelemente sollte mehr als 50mm², insbesondere mehr als 250mm² betragen.

Dabei kann vorgesehen sein, dass mindestens ein Spannelement das Verbund-Hochfrequenzschwingsystem zumindest teilweise oder größtenteils umschließt. Zu diesem Zweck kann dieses Spannelement einen ringförmigen oder ringsegmentförmigen Querschnitt aufweisen, so dass dieses Spannelement das Verbund-Hochfrequenzschwingsystem teilweise oder vollständig umschließt.

Mindestens ein Spannelement kann mittels mindestens eines Gewindes, z.B. durch Verschrauben, gespannt sein.

Die Zugspannung des Spannelementes sollte unterhalb der Grenze zur plastischen Verformung liegen. Das heißt, die durch die Verspannung des Spannelementes eingebrachte Zugspannung sollte geringer sein als die Streckgrenze Re des Spannelementes. Mindestens ein Spannelement kann eine Elastizität aufweisen, welche toleranzausgleichend wirkt.

Es kann mindestens ein Spannelement zur Verspannung eines weiteren Verbund-Hochfrequenzschwingsystems verwendet werden. Das heißt, dass die erfindungsgemäße Vorrichtung eine Mehrzahl von Verbund-Hochfrequenzschwingsystemen aufweisen kann, und wenigstens ein Spannelement zur Verspannung mehrerer Verbund-Hochfrequenzschwingsysteme dienen kann.

Vorzugsweise erfolgt die Kraftübertragung von mindestens einem Spannelement auf das Verbund-Hochfrequenzschwingsystem nahe oder in unmittelbarer Nähe oder direkt an einem Minimum (Knoten) der in Längsrichtung zum Verbund-Hochfrequenzschwingsystem auftretenden mechanischen Schwingungen.

Erfindungsgemäß ist vorgesehen, dass die Kraftübertragung von mindestens einem Spannelement auf das Verbund-Hochfrequenzschwingsystem in einem Abstand von weniger als 0,1 Lambda zu einem Minimum (Knoten) der in Längsrichtung zum Verbund-Hochfrequenzschwingsystem auftretenden mechanischen Schwingungen erfolgt.

Die Kraftübertragung kann von mindestens einem Spannelement auf das Verbund-Hochfrequenzschwingsystem mindestens an einem Ende des Spannelements außen am Verbund-Hochfrequenzschwingsystem anliegend erfolgen, insbesondere auf ein Materialendstück pressend.

Alternativ erfolgt die Kraftübertragung von mindestens einem Spannelement auf das Verbund-Hochfrequenzschwingsystem über mindestens ein Koppelelement.

Vorzugsweise wird mindestens eine schwingungsentkoppelnde, - absorbierende und/oder dämpfende Geometrie zur Verringerung der vom Verbund-Hochfrequenzschwingsystem auf mindestens ein Spannelement übertragenen Schwingungen verwendet.

Weiterhin ist vorteilhafterweise vorgesehen, dass die Resonanzfrequenz des Spannelementes von der Erregerfrequenz des Verbund-Hochfrequenzschwingsystems abweicht. Das heißt, dass mindestens ein Spannelement keine Resonanzfrequenz aufweist, welche nahe der Erregerfrequenz des Verbund-Hochfrequenzschwingsystems liegt.

Bei Verwendung mehrerer Spannelemente sollten mindestens zwei Spannelemente voneinander unterschiedliche Resonanzfrequenzen aufweisen.

Mindestens ein Spannelement kann elektrisch isolierend oder isoliert ausgeführt sein.

Des Weiteren kann vorgesehen sein, dass mindestens ein Spannelement oder mindestens ein Koppelelement zur Leitung von Wärme bzw. thermischer Energie, z.B. zur Wärmeableitung oder zur Führung von Temperierfluiden, wie z.B. Öl, Wasser oder Pressluft verwendbar ist.

Insbesondere zu diesem Zweck kann ein schwingungs- bzw. ultraschallerzeugendes Element Öffnungen zur Durchleitung wärmeableitender Stoffe, wie Flüssigkeiten oder Gase aufweisen.

Die erfindungsgemäße Vorrichtung lässt sich dadurch herstellen, dass
mindestens ein Spannelement außerhalb des Materialquerschnitts mindestens eines schwingungserzeugenden Elementes positioniert wird. Dort kann es derart gespannt werden, dass es eine Spannung auf das schwingungserzeugende Element ausübt.

Durch das erfindungsgemäße Positionieren eines oder mehrerer Spannelemente außerhalb des Materialquerschnitts der ultraschallerzeugenden, z.B. der piezokeramischen, Elemente ist es möglich, dass die Materialquerschnittsumme der Spannelemente den Materialquerschnitt der ultraschallerzeugenden, z.B. der piezokeramischen, Elemente nicht oder nicht erheblich reduziert. Außerdem wird die Materialquerschnittsumme der Spannelemente nicht durch die Geometrie der ultraschallerzeugenden Elemente begrenzt.

Dafür werden ein oder mehrere Spannelemente außerhalb des Materialquerschnitts der ultraschallerzeugenden Elemente positioniert. So ist es möglich Spannelemente mit einer hohen Summe minimaler Spannelement-Materialquerschnitte zu verwenden diese Summe kann mehr als 50mm², vorzugsweise mehr als 250mm², z.B. 60mm² betragen.

Die Spannelemente können unter anderem aus metallischen, nicht-metallischen oder keramischen Materialien oder aus Kunststoffen oder Verbundwerkstoffen, insbesondere aus Titan, Titanlegierungen, Stahl oder Stahllegierungen, Aluminium, Polymeren, Hochleistungskunststoffen oder Aluminiumlegierungen, z.B. aus Titan grade 5 gefertigt sein. Spannelemente, welche aus mehr als einem Materialstück bestehen können auf verschiedene Weise, z.B. durch Verschrauben, Einhaken, Kleben, Knoten, Verseilen, Verweben, Schrumpfen oder Pressen zu einem Verbund zusammen gefügt werden. Die Querschnittsgeometrie der einzelnen Spannelemente kann entlang der Längsrichtung des Verbund-Hochfrequenzschwingsystems variieren. So sind unter anderem kreisförmige, halbkreisförmige, kreissegmentförmige, viereckige (z.B. Vierkant), sechseckige (z.B. Sechskant), ringförmige (z.B. Rohr) und ringsegmentförmige oder polygene Querschnittsgeometrien (z.B. Seil) möglich. Die Querschnittsgeometrie eines oder mehrerer Spannelemente kann das Verbund-Hochfrequenzschwingsystem teilweise, größtenteils oder vollständig umschließen.

Die an den Spannelementen anliegende Zugkraft kann z.B. durch Verschrauben, thermische Kontraktion bei Abkühlung, thermischer Expansion, chem. Beeinflussung oder mittels Hebeln, hydraulischer Zylinder, Piezo-Aktuatoren, Federn, Getrieben oder schiefer Ebenen, vorzugsweise durch Verschrauben erzeugt werden. Diese Vorrichtungen zum Aufbringen der Zugkraft können einseitig, beidseitig oder mehrseitig, z.B. an einem oder mehreren Spannelementen angebracht sein.

Die Zugspannung der Spannelemente sollte vorzugsweise unterhalb der Grenze der plastischen Verformung oder Rissbildung liegen. Die Spannelemente können sich unter Einwirkung der Zugspannung elastisch verformen, z.B. in Zugrichtung ausdehnen. Diese Elastizität kann toleranzausgleichend wirken.

Die Spannelemente können sich unter thermischer Einwirkung, z.B. während des Betriebes des Verbund-Hochfrequenzschwingsystems verformen, z.B. in Zugrichtung ausdehnen. Diese Verformung kann zu einer Variation der Zugspannung führen. Diese Variation der Zugspannung kann bewusst zur Steuerung der am Verbund-Hochfrequenzschwingsystem anliegenden Flächenpressung und Flächenpressungsverteilung verwendet werden. Die Anordnung außerhalb liegender Spannelemente kann so gewählt und z.B. mit innenliegenden Spannelemente kombiniert werden, dass die am Verbund-Hochfrequenzschwingsystem anliegende Flächenpressung und Flächenpressungsverteilung entlang des Querschnitts möglichst gleichmäßig verteilt ist.

Einzelne Spannelemente können zur Verspannung von mehr als einem Verbund-Hochfrequenzschwingsystem verwendet werden.

Die Kraftübertragung von einem Spannelement auf das Verbund-Hochfrequenzschwingsystem kann an beliebiger Stelle erfolgen. Vorzugsweise sollte die Kraftübertragung nahe oder in unmittelbarer Nähe eines Minimums (Knotens) der in Längsrichtung zum Verbund-Hochfrequenzschwingsystem auftretenden mechanischen Schwingungen erfolgen. Der Abstand in Längsrichtung der zum Verbund-Hochfrequenzschwingsystem auftretenden mechanischen Schwingungen zu einem derartigen Minimum kann z.B. zwischen 0 und 0,2 Lambda, vorzugsweise 0 bis 0,1 Lambda, z.B. 0,02 Lambda betragen.

Die Übertragung kann z.B. über außen am Verbund-Hochfrequenzschwingsystem anliegende oder auf die Enden eines Lambda/2 Elements pressende Koppelelemente erfolgen. Zur Reduzierung der vom Verbund-Hochfrequenzschwingsystem auf die Spannelemente übertragenen mechanischen Schwingungen können diese Koppelemente oder die Spannelemente selbst schwingungsentkoppelnde, -absorbierende oder -dämpfende Bestandteile oder Geometrien aufweisen. Diese Bestandteile können unter anderem aus Kunststoffen, Verbundwerkstoffen, Harzen oder Metallen, z.B. aus Gummi bestehen.

Falls eine Übertragung mechanischer Schwingungen vom Verbund-Hochfrequenzschwingsystem auf die Spannelemente nicht vollständig ausgeschlossen werden kann, sollten die Spannelemente vorzugsweise keine Resonanzfrequenzen aufweisen, welche nahe der Erregerfrequenz des Verbund-Hochfrequenzschwingsystems liegen. Die Resonanzfrequenzen der Spannelemente können unter anderem durch die Geometrie, wie z.B. die Länge, die Materialauswahl und durch die Anordnung der Koppelstelle oder Koppelelemente beeinflusst werden. Die einzelnen Spannelemente können untereinander variieren, so dass sie z.B. voneinander abweichende Resonanzfrequenzen für Biegeschwingungen aufweisen. Zur Reduzierung oder Vermeidung der elektrischen Spannungsübertragung vom Verbund-Hochfrequenzschwingsystem auf die Spannelemente können die Koppelemente oder die Spannelemente selbst elektrisch isolierende Bestandteile aufweisen. Diese Bestandteile können unter anderem aus Kunststoffen, Verbundwerkstoffen, Harzen, Keramik, Beton, Glas, z.B. aus Beton bestehen.

Alternativ können die Spannelemente und/oder die Koppelelemente durch eine geeignete Gestaltung als Leiter für die Übertragung elektrischer Energie, z.B. als Schutzleiter oder zur Leitung thermischer Energie, z.B. zur Wärmeableitung oder zur Führung von Temperierfluiden, wie z.B. Öl, Wasser oder Pressluft verwendet werden.

Innerhalb Materialquerschnitts der ultraschallerzeugenden Elemente können Öffnungen zur Durchleitung wärmeableitender Stoffe, wie Flüssigkeiten oder Gase, z.B. Öl, Wasser, Luft oder Edelgas positioniert sein. Diese Stoffe können mit einem vom Umgebungsdruck abweichenden Druck, z.B. mit einem Überdruck bewegt oder beaufschlagt werden. Die Kontaktflächen zwischen diesen Stoffen und dem Verbund-Hochfrequenzschwingsystem können zur Übertragung thermischer Energie, z.B. zur Kühlung verwendet werden.

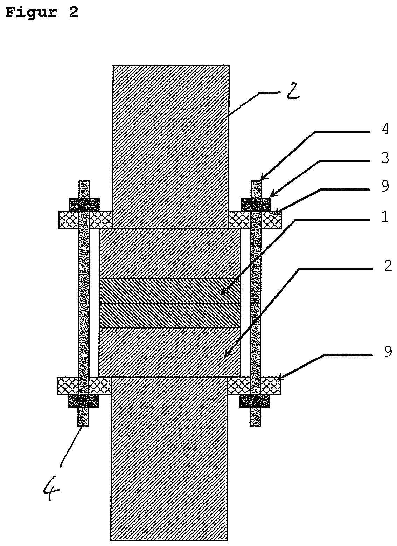

Die Erfindung soll nachstehend anhand der in den beiliegenden Figuren 2 bis 6 dargestellten Ausführungsbeispiele näher erläutert werden. In den zugehörigen Zeichnungen wird folgendes gezeigt.

Figur 2 zeigt eine Art einer erfindungsgemäßen Vorrichtung. Ein Verbund-Hochfrequenzschwingsystem umfasst ein Lambda/2-Element, welches zwei piezokeramische Scheiben (1) zwischen zwei Materialstücken (2) aufweist. Diese Materialstücke (2) sind mittels zweier Spannelemente (4) und zweier außen an den Materialstücken (2) anliegender Koppelstücke (9) verspannt. Die Spannelemente (4) sind außerhalb der Querschnittsgeometrie der piezokeramischen Scheiben (1) positioniert. Die an den Spannelementen anliegende Zugkraft wird mittels Muttern (3) durch Verdrehen aufgebracht.

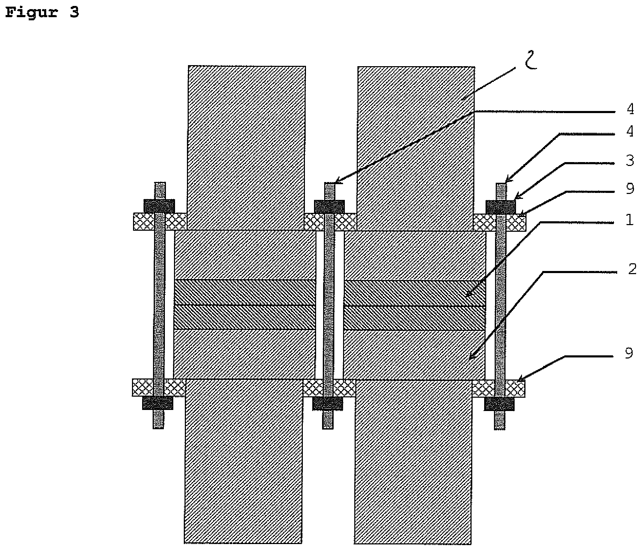

Figur 3 zeigt eine ähnliche Variante wie Figur 2, jedoch mit zwei parallel angeordneten Verbund-Hochfrequenzschwingsystemen Eines der Spannelemente (4) wird zur Verspannung beider Verbund-Hochfrequenzschwingsysteme verwendet.

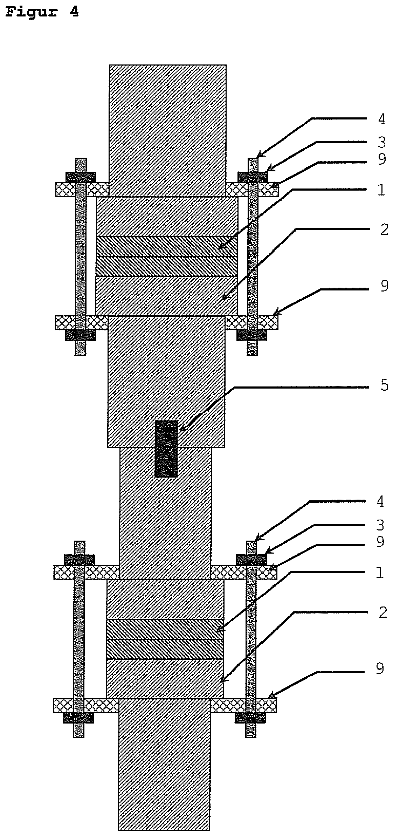

Figur 4 zeigt eine ähnliche Variante wie Figur 2, jedoch mit zwei in Längsrichtung mittels Gewindebolzen (5) verbundenen Lambda/2-Elementen, von denen jedes zwei piezokeramische Scheiben (1) aufweist.

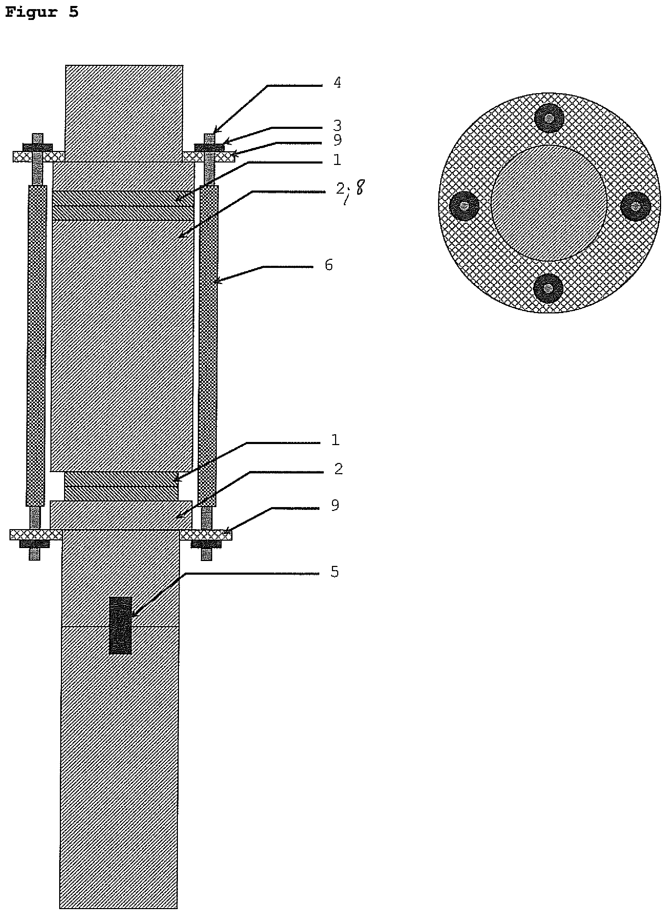

Figur 5 zeigt eine ähnliche Variante wie Figur 2, jedoch mit zwei in Längsrichtung über ein gemeinsames Materialstück (8) verbundenen Lambda/2-Elementen und einem weiteren mittels Gewindebolzen (5) verbundenen Labda/2-Element ohne piezokeramische Scheiben. Die 4 Spannelemente (4) weisen je ein Verbindungsrohr (6) auf.

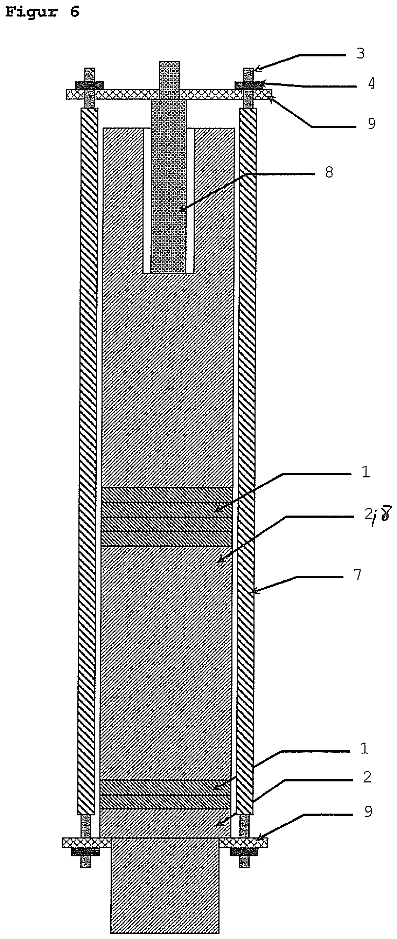

Figur 6 zeigt eine ähnliche Variante wie Figur 2, jedoch mit zwei in Längsrichtung über ein gemeinsames Materialstück (8) verbundenen Lambda/2-Elementen. Die Spannelemente (4) weisen je eine Isolation (7) auf. Ein weiteres Koppelelement (Druckstück) (10) dient zur Kraftübertragung auf das VHFSVerbund-Hochfrequenzschwingsystem. Allen Varianten ist gemein, dass die Spannelemente (4) außerhalb der ultraschallerzeugenden Elemente (1) positioniert sind.

Die Figur 6 zeigt drei rotationssymmetrische in Längsrichtung verbundene Lambda/2-Elemente. Die Materialstücke (2 und 8) sind z.B. aus Titan grade 5 gefertigt. Der Durchmesser der piezokeramischen Elemente (1) beträgt z.B. 80mm. Zwei Spannelemente (3) bestehen aus einer Stahllegierung und weisen ein Außengewinde, z.B. M6, auf. Die Länge der Spannelemente (3) beträgt z.B. je 360mm. Die Spannelemente sind auf einem Teil ihrer Länge durch die Isolation (7) bedeckt. Die Koppelelemente (9) bestehen aus Aluminium. Das Koppelstück (Druckstück) (8) überträgt eine Spannkraft von 500kN auf das Lambda/2-Element. Die Position der Kraftübertragung ist so gewählt, dass sie sich nahe dem Schwingungsminimum der Längsschwingungen des oberen Lambda/2-Elements befindet. Die Erregerfrequenz des Verbund-Hochfrequenzsystems beträgt 19kHz und ist für die Übertragung von Ultraschall mit einer Leistung von bis zu 4kW im Dauerbetrieb ausgelegt.

### Liste der Bezugszeichen

- 1: ultraschallerzeugendes Element
- 2: Materialstück
- 3: Mutter (Innengewinde)
- 4: Spannelement mit Außengewinde
- 5: Gewindebolzen
- 6: Verbindungsrohr mit Innengewinde
- 7: Isolation
- 8: Materialstück
- 9: Koppelelement
- 10: Koppelelement (Druckstück)

## Patentansprüche

1. Vorrichtung zur Erzeugung von elektromechanischen Verbund-Hochfrequenzschwingungen, umfassend ein Verbund-Hochfrequenzschwingsystem mit mindestens einem schwingungserzeugendem Element (1) und mindestens ein Spannelement (4) zur Druckbeaufschlagung des schwingungserzeugenden Elementes (1), wobei mindestens ein Spannelement (4) außerhalb der Querschnittsgeometrie mindestens eines schwingungserzeugenden Elementes (1) positioniert ist und das Verbund-Hochfrequenzschwingsystem dazu ausgelegt ist, mit einer Frequenz zwischen 15 kHz und 200 kHz und einer Amplitude von 1 µm bis 350 µm zu schwingen,
**dadurch gekennzeichnet, dass**
die Kraftübertragung vom Spannelement (4) auf das Verbund-Hochfrequenzschwingsystem in einem Abstand von weniger als 0,1 Lambda zu einem Minimum (Knoten) der in Längsrichtung zum Verbund-Hochfrequenzschwingsystem auftretenden mechanischen Schwingungen erfolgt, wobei Lambda die Wellenlänge ist, welche sich aus der Frequenz und der Schallausbreitungsgeschwindigkeit im Hochfrequenzschwingsystem ergibt.

2. Vorrichtung nach Anspruch 1 **dadurch gekennzeichnet, dass** mindestens zwei Spannelemente (4) außerhalb der Querschnittsgeometrie mindestens eines schwingungserzeugenden Elementes (1) positioniert sind.

3. Vorrichtung nach mindestens einem der vorhergehenden Ansprüche, **dadurch gekennzeichnet, dass** die schwingungserzeugenden Elemente (1) piezokeramische Elemente sind.

4. Vorrichtung nach mindestens einem der vorhergehenden Ansprüche, **dadurch gekennzeichnet, dass** das Verbund-Hochfrequenzschwingsystem mindestens zwei entlang seiner Längsrichtung hintereinander angeordnete Lambda/2-Elemente aufweist.

5. Vorrichtung nach mindestens einem der vorhergehenden Ansprüche, **dadurch gekennzeichnet, dass** mindestens ein Spannelement (4) das Verbund-Hochfrequenzschwingsystem zumindest teilweise umschließt.

6. Vorrichtung nach mindestens einem der vorhergehenden Ansprüche, **dadurch gekennzeichnet, dass** mindestens ein Spannelement (4) mittels mindestens eines Gewindes, z.B. durch Verschrauben gespannt ist.

7. Vorrichtung nach mindestens einem der vorhergehenden Ansprüche, **dadurch gekennzeichnet, dass** eine im Spannelement (4) herrschende Zugspannung unterhalb der Grenze zur plastischen Verformung dieses Spannelements (4) liegt.

8. Vorrichtung nach mindestens einem der vorhergehenden Ansprüche, **dadurch gekennzeichnet, dass** die Kraftübertragung vom Spannelement (4) auf das Verbund-Hochfrequenzschwingsystem an einem Minimum (Knoten) der in Längsrichtung zum Verbund-Hochfrequenzschwingsystem auftretenden mechanischen Schwingungen erfolgt.

9. Vorrichtung nach mindestens einem der vorhergehenden Ansprüche, **dadurch gekennzeichnet, dass** die Kraftübertragung vom Spannelement (4) auf das Verbund-Hochfrequenzschwingsystem mindestens an einem Ende des Spannelements (4) pressend auf ein Materialstück erfolgt.

10. Vorrichtung nach mindestens einem der vorhergehenden Ansprüche, **dadurch gekennzeichnet, dass** die Kraftübertragung vom Spannelement (4) auf das Verbund-Hochfrequenzschwingsystem über mindestens ein Koppelelement erfolgt.

11. Vorrichtung nach mindestens einem der vorhergehenden Ansprüche, **dadurch gekennzeichnet, dass** die Resonanzfrequenz des Spannelementes (4) von der Erregerfrequenz des Verbund-Hochfrequenzschwingsystems abweicht.

12. Vorrichtung nach mindestens einem der vorhergehenden Ansprüche, **dadurch gekennzeichnet, dass** mindestens zwei Spannelemente (4) voneinander unterschiedliche Resonanzfrequenzen aufweisen.

13. Vorrichtung nach mindestens einem der vorhergehenden Ansprüche, **dadurch gekennzeichnet, dass** mindestens ein Spannelement (4) und/ oder mindestens ein Koppelelement derart ausgestaltet ist, dass mit diesem Element Wärme leitbar ist.

14. Vorrichtung nach mindestens einem der vorhergehenden Ansprüche, **dadurch gekennzeichnet, dass** mindestens ein schwingungserzeugendes Element (1) Öffnungen zur Durchleitung wärmeleitender Stoffe aufweist.

## Claims

1. Device for generating electromechanical composite high-frequency oscillations, comprising a composite high-frequency oscillation system having at least one oscillation-generating element (1) and at least one bracing element (4) for applying pressure to the oscillation-generating element (1),
wherein at least one bracing element (4) is positioned outside of the cross-sectional geometry of at least one oscillation-generating element (1) and the composite high-frequency oscillation system is configured to oscillate at a frequency between 15 kHz and 200 kHz and with an amplitude of 1 µm to 350 µm,
**characterised in that**
the force is transmitted from the bracing element (4) to the composite high-frequency oscillation system at a distance of less than 0.1 lambda to a minimum (node) of the mechanical oscillations that occur in the longitudinal direction of the composite high-frequency oscillation system, wherein lambda is the wavelength resulting from the frequency and the sound propagation speed in the high-frequency oscillation system.

2. Device according to claim 1, **characterised in that** at least two bracing elements (4) are positioned outside of the cross-sectional geometry of at least one oscillation-generating element (1).

3. Device according to at least one of the preceding claims, **characterised in that** the oscillation-generating elements (1) are piezo-ceramic elements.

4. Device according to at least one of the preceding claims, **characterised in that** the composite high-frequency oscillation system has at least two lambda/2 elements that are successively arranged along its longitudinal direction.

5. Device according to at least one of the preceding claims, **characterised in that** at least one bracing element (4) at least partially encloses the composite high-frequency oscillation system.

6. Device according to at least one of the preceding claims, **characterised in that** at least one bracing element (4) is braced, for example screwed together, with at least one thread.

7. Device according to at least one of the preceding claims, **characterised in that** a tensile stress prevailing in the bracing element (4) is below the plastic deformation limit of said bracing element (4).

8. Device according to at least one of the preceding claims, **characterised in that** the force is transmitted from the bracing element (4) to the composite high-frequency oscillation system at a minimum (node) of the mechanical oscillations that occur in the longitudinal direction of the composite high-frequency oscillation system.

9. Device according to at least one of the preceding claims, **characterised in that** the force is transmitted from the bracing element (4) to the composite high-frequency oscillation system at least at one end of the bracing element (4) by applying pressure to a piece of material.

10. Device according to at least one of the preceding claims, **characterised in that** the force is transmitted from the bracing element (4) to the composite high-frequency oscillation system via at least one coupling element.

11. Device according to at least one of the preceding claims, **characterised in that** the resonance frequency of the bracing element (4) differs from the excitation frequency of the composite high-frequency oscillation system.

12. Device according to at least one of the preceding claims, **characterised in that** at least two bracing elements (4) have mutually different resonance frequencies.

13. Device according to at least one of the preceding claims, **characterised in that** at least one bracing element (4) and/or at least one coupling element is designed in such a way that heat can be conducted with said element.

14. Device according to at least one of the preceding claims, **characterised in that** at least one oscillation-generating element (1) has openings for conducting heat-conducting materials.

## Revendications

1. Dispositif pour générer des oscillations haute fréquence composites électromécaniques, comprenant un système oscillant haute fréquence composite avec au moins un élément (1) générateur d'oscillations et au moins un élément de contrainte (4) pour solliciter en pression l'élément (1) générateur d'oscillations, au moins un élément de contrainte (4) étant positionné à l'extérieur de la géométrie de section transversale d'au moins un élément (1) générateur d'oscillations, et le système oscillant haute fréquence composite étant conçu pour osciller avec une fréquence comprise entre 15 kHz et 200 kHz et avec une amplitude de 1 µm à 350 µm,
**caractérisé en ce que**
la transmission de force à partir de l'élément de contrainte (4) vers le système oscillant haute fréquence composite s'effectue à une distance inférieure à 0,1 lambda d'un minimum (noeud) des oscillations mécaniques apparaissant dans le direction longitudinale par rapport au système oscillant haute fréquence, lambda étant la longueur d'ondes qui résulte de la fréquence et de la vitesse de propagation du son dans le système oscillant haute fréquence.

2. Dispositif selon la revendication 1, **caractérisé en ce qu'**au moins deux éléments de contrainte (4) sont positionnés à l'extérieur de la géométrie de section transversale d'au moins un élément (1) générateur d'oscillations.

3. Dispositif selon au moins l'une quelconque des revendications précédentes, **caractérisé en ce que** les éléments(1) générateurs d'oscillations sont des éléments céramiques piézoélectriques.

4. Dispositif selon au moins l'une quelconque des revendications précédentes, **caractérisé en ce que** le système oscillant haute fréquence composite présente au moins deux éléments lambda/2 disposés l'un derrière l'autre le long de sa direction longitudinale.

5. Dispositif selon au moins l'une quelconque des revendications précédentes, **caractérisé en ce qu'**au moins un élément de contrainte (4) entoure au moins partiellement le système oscillant haute fréquence composite.

6. Dispositif selon au moins l'une quelconque des revendications précédentes, **caractérisé en ce qu'**au moins un élément de contrainte (4) est serré au moyen d'au moins un filetage, par ex. par vissage.

7. Dispositif selon au moins l'une quelconque des revendications précédentes, **caractérisé en ce qu'**une contrainte de traction régnant dans l'élément de contrainte (4) est inférieure à la limite de déformation plastique de cet élément de contrainte (4).

8. Dispositif selon au moins l'une quelconque des revendications précédentes, **caractérisé en ce que** la transmission de force à partir de l'élément de contrainte (4) vers le système oscillant haute fréquence composite s'effectue sur un minimum (noeud) des oscillations mécaniques apparaissant dans la direction longitudinale par rapport au système oscillant haute fréquence composite.

9. Dispositif selon au moins l'une quelconque des revendications précédentes, **caractérisé en ce que** la transmission de force à partir de l'élément de contrainte (4) vers le système oscillant haute fréquence composite s'effectue au moins à une extrémité de l'élément de contrainte (4) avec l'exercice d'une pression sur un morceau de matériau.

10. Dispositif selon au moins l'une quelconque des revendications précédentes, **caractérisé en ce que** la transmission de force à partir de l'élément de contrainte (4) vers le système oscillant haute fréquence composite s'effectue par le biais d'au moins un élément de couplage.

11. Dispositif selon au moins l'une quelconque des revendications précédentes, **caractérisé en ce que** la fréquence de résonance de l'élément de contrainte (4) diffère de la fréquence d'excitation du système oscillant haute fréquence composite.

12. Dispositif selon au moins l'une quelconque des revendications précédentes, **caractérisé en ce qu'**au moins deux éléments de contrainte (4) présentent des fréquences de résonance différentes l'une de l'autre.

13. Dispositif selon l'une quelconque des revendications précédentes, **caractérisé en ce qu'**au moins un élément de contrainte (4) et/ou au moins un élément de couplage est/sont constitué(s) de telle sorte que de la chaleur peut être conduite avec cet élément.

14. Dispositif selon au moins l'une quelconque des revendications précédentes, **caractérisé en ce qu'**au moins un élément (1) générateur d'oscillations présente des ouvertures pour le passage de substances conduisant la chaleur.
